# EUROPEAN PATENT APPLICATION

(11) **EP 4 709 108 A1**
(43) Date of publication of application: **11.03.2026**
(21) Application number: 25200995.6
(22) Date of filing: 09.09.2025
(51) Int. Cl.: H10H 20/851, H10H 20/80

(54) **WAVELENGTH CONVERTER AND LED DIE FOR CORRECTING EDGE COLOR SHIFT AND METHODS OF MANUFACTURE**

(30) Priority: 10.09.2024 US 202418830069
(71) Applicant: Lumileds Singapore Pte. Ltd, Singapore 768925 (SG)
(72) Inventor: MONESTIER, Florent Gregoire, 52068 Aachen (DE); MIKKENIE, Ronald, 52068 Aachen (DE); SHEN, Yu-Chen, San Jose, CA 95131 (US)
(74) Representative: Cohausz & Florack

(57) **Abstract**

An LED die, a wafer of LED dies, and methods of manufacture are described. A shaped surface luminance wavelength converter platelet includes a first wavelength converting layer, which has a first concentration of scattering pores. A second wavelength converting layer is disposed over the first wavelength converting layer and has a second concentration of scattering pores with the second concentration of scattering pores being larger than the first concentration of scattering pores.

## Description

### BACKGROUND

Light-emitting diodes (LEDs) are increasingly more used in lighting applications, such as automotive lighting systems or general illumination applications, for example, instead of more conventionally used filament lights. In some applications, shaped surface luminance LED dies may be used to control the luminance distribution of light emitted by the LEDs over the surface area of such LED dies. The luminance distribution can be represented in graph form in a luminance map, where a series of peaks and valleys may define the regions of the LED's surface area where the luminance is higher than average or lower than average, with the highest points or points being referred to as peak luminance.

### SUMMARY

An LED die, a wafer of LED dies, and methods of manufacture are described. A shaped surface luminance wavelength converter platelet includes a first wavelength converting layer, which has a first concentration of scattering pores. A second wavelength converting layer is disposed over the first wavelength converting layer and has a second concentration of scattering pores with the second concentration of scattering pores being larger than the first concentration of scattering pores.

### BRIEF DESCRIPTION OF THE DRAWINGS

A more detailed understanding can be had from the following description, given by way of example in conjunction with the accompanying drawings wherein:
FIG. 1A is a top view of a first example shaped surface luminance LED die;
FIG. 1B is a second example shaped surface luminance LED die;
FIG. 2 is a graph showing an example of a typical intrinsic internal quantum efficiency (IQE) drop of a blue epitaxial active stack as a function of current density and temperature;
FIG. 3A is a diagram showing examples of blue source emittance and color and luminance distributions of a conventional uniform die;
FIG. 3B is a diagram showing examples of color and luminance distributions of an example edge shift luminance (ESL) die;
FIG. 3C is a diagram showing examples of blue source emittance and color and luminance distributions of an example center peak luminance (CPL) die;
FIG. 4A is a perspective view of an example wavelength converter platelet for a shaped luminance LED die;
FIG. 4B is a cross-sectional view of the example wavelength converter platelet of FIG. 4A taken along the line X-X in FIG. 4A;
FIG. 5 includes diagrams showing a shaped luminance distribution and associated v' distribution for a wavelength converter having non-uniform scattering efficacy over the area, such as the wavelength converter illustrated in FIGs. 4A and 4B;
FIG. 6A is a flow diagram of an example method of manufacturing a conventional shaped surface luminance die based on current distribution adjustment;
FIG. 6B is a flow diagram of an example method of manufacturing a shaped surface luminance die based on spatial variation of platelet scattering efficacy;
FIG. 7A is a flow diagram of an example method of manufacturing a shaped surface luminance wavelength converter; and
FIG. 7B includes diagrams of a shaped surface luminance wavelength converter at various steps in a method of manufacture.

### DETAILED DESCRIPTION

Examples of different light illumination systems and/or light emitting diode ("LED") implementations will be described more fully hereinafter with reference to the accompanying drawings. These examples are not mutually exclusive, and features found in one example may be combined with features found in one or more other examples to achieve additional implementations. Accordingly, it will be understood that the examples shown in the accompanying drawings are provided for illustrative purposes only and they are not intended to limit the disclosure in any way. Like numbers refer to like elements throughout.

It will be understood that, although the terms first, second, third, etc. may be used herein to describe various elements, these elements should not be limited by these terms. These terms may be used to distinguish one element from another. For example, a first element may be termed a second element and a second element may be termed a first element without departing from the scope of the present invention. As used herein, the term "and/or" may include any and all combinations of one or more of the associated listed items.

It will be understood that when an element such as a layer, region, or substrate is referred to as being "on" or extending "onto" another element, it may be directly on or extend directly onto the other element or intervening elements may also be present. In contrast, when an element is referred to as being "directly on" or extending "directly onto" another element, there may be no intervening elements present. It will also be understood that when an element is referred to as being "connected" or "coupled" to another element, it may be directly connected or coupled to the other element and/or connected or coupled to the other element via one or more intervening elements. In contrast, when an element is referred to as being "directly connected" or "directly coupled" to another element, there are no intervening elements present between the element and the other element. It will be understood that these terms are intended to encompass different orientations of the element in addition to any orientation depicted in the figures.

Relative terms such as "below," "above," "upper,", "lower," "horizontal" or "vertical" may be used herein to describe a relationship of one element, layer, or region to another element, layer, or region as illustrated in the figures. It will be understood that these terms are intended to encompass different orientations of the device in addition to the orientation depicted in the figures.

Having described the embodiments in detail, those skilled in the art will appreciate that, given the present description, modifications may be made to the embodiments described herein without departing from the spirit of the inventive concept. Therefore, it is not intended that the scope of the invention be limited to the specific embodiments illustrated and described.

Analysis of some automotive system optics suggests that a shaped surface luminance LED, where the peak luminance resides in the center of the LED, provides the best system performance for system optics with a total internal reflectance (TIR) lens. On the other hand, LED surface luminance with a gradient from one side to another side may provide the best system performance for system optics with a reflector. This is by contrast to a uniform die where the surface luminance is more evenly disbursed. System optical performance may be evaluated via a system optics figure of merit (FOM), which may evaluate both the intensity and quality of light distribution on the road. In the embodiments described herein, an LED die with a center peak luminance distribution may be referred to as a center peak luminance (CPL) die, and an LED die with edge shift luminance may be referred to as an edge shift luminance (ESL) die. In general, a die with shaped luminance profile may be defined as a die where the luminance averaged over an area equal to at least ten percent (10%) of the entire light emitting area deviates more than twenty percent (20%) of the mean luminance averaged over the entire light emitting area. The area where luminance deviates the most may be referred to as the peak luminance.

While shaped surface luminance LEDs can be advantageous for certain applications, as discussed above, such LEDs can also cause potentially unwanted color variation in the light emitted from the LED. Such variation may be assessed by analyzing, for example, system optical metrics, such as efficacy (which may be determined by Vf and LED flux), color over source (CoS) variation, and/or color over angle and thermal resistance. Efficacy may be important as, for the same power, more dies may be needed to obtain required flux on the road. Additionally, lower efficacy means that more power is needed to get the required flux on the road, which leads to higher temperature. Finally, thermal resistance may also be very important as higher thermal resistance may require a larger heat sink.

Conventional shaped surface luminance LEDs promote current injection into specific parts of the LED die. This is conventionally done using larger vias or higher density vias in areas where higher current density is desired. Vias may be described as metal cylinders or pillars that connect an electrically large conductive layer with a doped semiconductor.

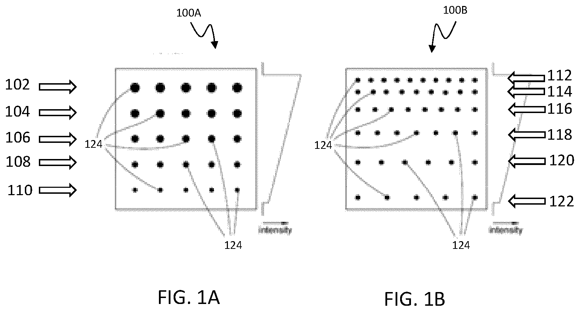

FIG. 1A is a top view of a first example shaped surface luminance LED die 100A. In the example illustrated in FIG. 1A, different sized vias 124 are used to promote current injection into areas of the die where higher current density is desired. The surface luminance LED die 100A includes five rows of vias 102, 104, 106, 108 and 110. The vias in row 102 are the largest in diameter, and the size of the vias decreases in each subsequent row 104, 106, 108 and 110. For example, the vias 124 in row 102 may be considered to have diameter D (not labeled). The vias in row 104 may have a diameter equal to 4D/5. The vias in row 106 may have a diameter equal to 3D/5. The vias in row 108 may have a diameter equal to 2D/5. The vias in row 110 may have a diameter equal to D/5.

FIG. 1B is a second example shaped surface luminance LED die 100B.In the example illustrated in FIG. 1B, via density is used to promote current injection into areas of the die where higher current density is desired. The shaped surface luminance LED die 100B includes six rows of vias 112, 114, 116, 118, 120 and 122. The spacing between rows 112 and 114 is the smallest, and spacing between rows increases moving towards the opposite edge of the die. For example, rows 112 and 114 of vias 124 are spaced the closest, rows 114 and 116 are spaced a little farther apart than rows 112 and 114, rows 116 and 118 are spaced a little farther apart than rows 112 and 114, and so on.

Conventional shaped surface luminance dies, such as illustrated, for example, in FIGs. 1A and 1B, which are based on current distribution adjustment, may have several disadvantages. First, there is a drop in internal quantum efficiency (IQE) at high current density and high temperature (also commonly referred to as the droop effect) that occurs near the peak luminance area of a shaped surface luminance die based on current distribution adjustment.

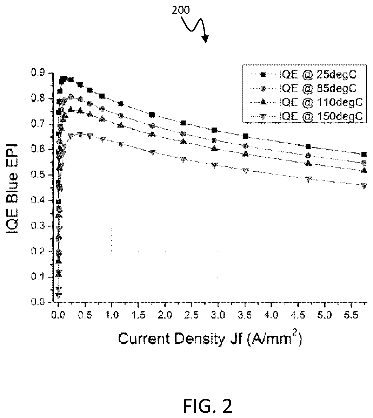

FIG. 2 is a graph 200 showing an example of a typical intrinsic IQE drop of a blue epitaxial active stack as a function of current density and temperature. In the example illustrated in FIG. 2, IQE drop versus current and temperature can be clearly seen. A maximum IQE is reached between 0.1 and 0.5 A/mm2, which is far from the typical current density used in automotive applications. At the end, the integral IQE of the device will depend strongly on the current uniformity as the areas with high current density will have a very low IQE. As a consequence, the IQE of a die with shaped surface luminance obtained by current injection distribution adjustment will always be lower than a device with uniform current density.

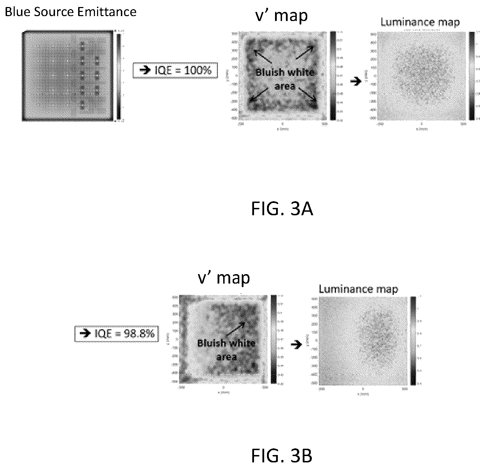

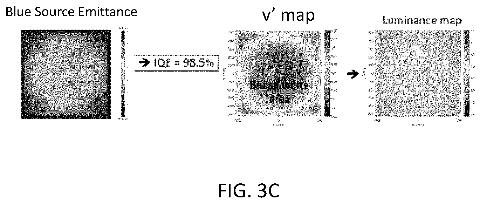

FIG. 3A is a diagram showing examples of blue source emittance and color and luminance distributions of a conventional uniform die. FIG. 3B is a diagram showing examples of color and luminance distributions of an example ESL die. FIG. 3C is a diagram showing examples of blue source emittance and color and luminance distributions of an example CPL die. In the illustrated examples, the IQE for the uniform die may be 100%. For the ESL die related to FIG. 3B, the IQE drops by 1.2% relative to the uniform die related to FIG. 3A. For the CPL die, the IQE penalty is slightly higher, dropping by 1.5% relative to the uniform die related to FIG. 3A and 0.3% relative to the ESL die related to FIG. 3B. Additionally, v' may vary by more than 30 points over the light emitting area for the ESL and CPL dies. In other words, in shaped surface luminance dies that make use of current injection into particular areas of the die, current crowding will be generated at locations corresponding to peak luminance, and it will be associated with dramatic IQE penalty due to current crowding and higher v'.

Another disadvantage of surface shaped luminance dies may be that the location where current and luminance are higher may match with the p/n gap junction where interconnect material is not present to avoid short circuiting. As a result, temperature and associated thermal resistance (Rₜₕ) may be higher compared to the uniform die.

Unfortunately, there are not many ways to avoid IQE reduction and higher v' of surface shaped luminance dies. The simplest solution is to reduce current uniformity, but the downside of this is the strong mitigation of luminance gradient and decrease of system performance.

To reduce the amount of increase of thermal resistance of a surface shaped luminance die based on current distribution adjustment, the peak current area may be made to overlap with an electrical pad in order to promote heat dissipation and avoid thermal gaps. In other words, the p/n junction separating the n and p electrical pads should not overlap the peak current area. However, this requires major design layout changes such as modifying the shape and position of electrical pads and designing compatible submount/tile, which is time consuming and expensive. Compared to a uniform die, then, surface shaped luminance dies based on current distribution will always require more development time and resources, will be more expensive, and will always have IQE and v' penalty, which will result in lower photometric flux.

Embodiments described herein include methods for generating a shaped surface luminance profile, and corresponding shaped surface luminance profile LED dies, based on lateral variation of scattering efficacy across the converter platelet. Such embodiments may be compatible with standard uniform die processes and may require specific design of the converter platelet only. Using such embodiments, the converter platelet can therefore be processed separately in parallel without requiring a new LED die design. In addition, IQE and thermal resistance penalties may be strongly reduced.

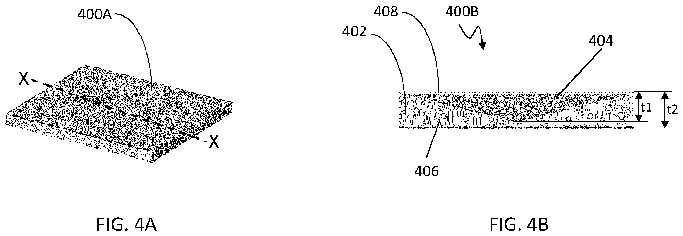

FIG. 4A is a perspective view of an example wavelength converter platelet 400A for a shaped luminance LED die. FIG. 4B is a cross-sectional view of the example wavelength converter platelet 400A of FIG. 4A taken along the line X-X in FIG. 4A. In the examples illustrated in FIGs. 4A and 4B, the converter 400A, 400B has a laterally varying concentration of scattering pores, resulting in a non-uniform scattering efficacy over the surface of the converter. By combining areas of the converter with high and low concentration of scattering pores, different scattering and therefore different conversion efficacy may be obtained over the light emitting area (LEA) 408. Areas with a higher concentration of scattering pores may provide higher yellow (or other color) phosphor conversion and, therefore, higher photometric power. On the other hand, areas with a lower concentration of scattering pores may provide less yellow (or other color) phosphor conversion, resulting in more blue light (or other color pump light) being emitted via the LEA 408 of the converter 400A, 400B and, therefore, lower photometric power.

In practical implementations, spatial variation of scattering efficacy may be obtained by non-uniformly combining two or more flat layers of converter with different scattering concentrations. The combined layer may, therefore, have scattering variation over the LEA 408 as the height ratio between the 2 or more converter layers varies across the LEA 408.

In the example illustrated in FIGs. 4A and 4B, the wavelength converting platelet 400A, 400B includes scattering pores 406 formed in both a first converter layer 402 and a second converter layer 404. In the first converter layer 402, the scattering pores 406 are less densely packed, while the scattering pores 406 in the second converter layer 404 are more densely packed. Scattering pores 406 within each of the respective first and second layers may be uniformly distributed. The scattering pores 406 can either be empty (or filled with air) or filled with a material that has properties such that when filled with such a material the scattering pores 406 will cause light to scatter upon impact with a scattering pore.

For simplicity, phosphor particles are not shown in FIGs. 4A and 4B**,** although phosphor particles would typically be present in both of layers 402 and 404. A base thickness t2 of the wavelength converter 400A, 400B may be approximately 73 µm (and may range between 25 µm and 200 µm). The wavelength converter 400A, 400B may be formed by non-uniformly combining 2 flat layers of converter material. In the center of the wavelength converter 400A, 400B, the thickness t1 of the second converter layer 404 with a high concentration of scattering pores may be approximately 61 µm, which may result in a ratio of ~80% of material with high concentration of scattering pores in the center. The magnitudes of t1 and t2 may be interdependent based, for example, on a target ratio. The magnitude of t1 may vary from a minimum of 0.6t2 to a minimum of 0.9t2. The volume ratio of converter layer with scattering pores may decrease linearly from the center to the edge of the wavelength converter 400A, 400B to reach a value close to zero at the edge of the platelet. Of course, the shape of the 2 converter layers and the percentage volume of scattering pores may be 3 different variables that may have the same effect. There will, therefore, be several combinations of converter layer shapes and air pore volume percentages that will result in the same luminance distribution.

The volume ratio of the scattering pores may vary from between 0.1% and 3.0%, while the diameter of the pores may vary between 1 µm and 5 µm, with a nominal diameter of 3.6 µm. By way of example, in the example illustrated in FIGs. 4A and 4B, the volume ratio of scattering pores in the second converter layer is 2.25 %, and the volume ratio of scattering pores in the first converter layers is 0.4%.

With the wavelength converter 400 having spatial variation of scattering efficacy, the desired luminance gradient may mainly be arrived at by color conversion variation as the blue power of the die is uniform. This, however, may be associated with strong color over source variation. This is not necessarily an issue as long as the color variation range is limited to 40 points of v', which is similar to the color variation range obtained with a POR surface shaped luminance die based on current density distribution adjustment.

For conventional surface shaped luminance dies, which have non-uniform current distribution, color variation is caused by a higher amount of oblique rays near the peak luminance area that may travel longer distances laterally through the wavelength converter and, therefore, are converted more than rays emitted near the peak luminance area. As a result, light emitted through portions of the wavelength converter that are spatially located farther away from the peak luminance area of the wavelength converter will be more yellow than light emitted through portions of the wavelength converter that are at or near the peak luminance area, which may appear very white-bluish. By way of comparison, for the wavelength converters described herein, light emitted through the wavelength converter near the center of the die will have a color point close to the integral color point while light emitted through the wavelength converter in portions farther away from peak luminance will have a bluish color point.

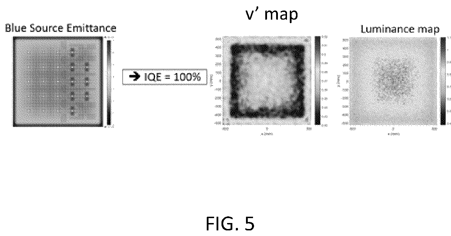

FIG. 5 includes diagrams showing a shaped luminance distribution and associated v' distribution for a wavelength converter having non-uniform scattering efficacy over the area, such the as the wavelength converter illustrated in FIGs. 4A and 4B. As can be seen from FIG. 5, embodiments of the shaped surface luminance die with spatial variation of scattering efficacy, as described herein, will have a similar luminance profile as conventional shaped surface luminance dies (e.g., dies where current is injected into particular regions of the die) due to the lower IQE penalty, will not require any specific LED die or submount design, and will not require development of a front end with a new die.

Different spatial variation profiles of scattering efficacy can be used to tune the surface luminance profile as desired. For example, a converter arrangement with a combination of 2 converter layers could be used to get an edge shift luminance profile (ESL) die. The thickness profile variation from the center to the edge of an individual converter layer will determine the luminance gradient. It is also important to keep in mind that color variation on the platelet overhang outer rim may still be present in both shaped surface luminance dies based on current distribution adjustment and shaped luminance dies based on spatial variation of platelet scattering efficacy.

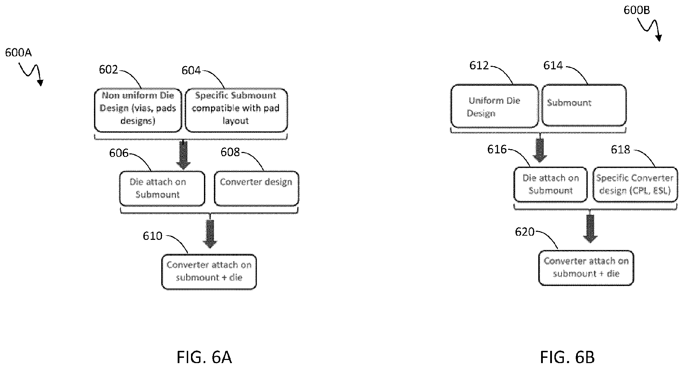

FIG. 6A is a flow diagram 600A of an example method of manufacturing a conventional shaped surface luminance die based on current distribution adjustment. In the example illustrated in FIG. 6A, a non-uniform shaped surface luminance LED die is designed and manufactured (602), and a specific submount is designed and manufactured for the LED die manufactured in 602 (e.g., to be compatible with the layout of the LED die manufactured in 602). Once the die and submount are designed and manufactured, the die may be attached to the submount (606). A wavelength converter may be designed and manufactured (608), and the wavelength converter may be attached to the submount on the die. The die attach, converter design, and converter attach may be performed using conventional methods, for example, while the die and submount must be designed and manufactured for each specific application.

FIG. 6B is a flow diagram 600B of an example method of manufacturing a shaped surface luminance die based on spatial variation of platelet scattering efficacy. In the example illustrated in FIG. 6B, a uniform die may be designed and manufactured (612), and a submount for the uniform die may be designed and manufactured (614). In contrast to the method illustrated in FIG. 6A, the LED die may be a conventional, uniform LED die, which may be used with a conventional submount. This makes the design and manufacture of the shaped surface luminance LED die much simpler as no special die needs to be designed and manufactured for each application and standard parts may be used. Similar to FIG. 6A, the die may be attached to the submount (616). In contrast to FIG. 6A, in the method illustrated in FIG. 6B, a shaped luminance wavelength converter platelet (e.g., CPL, ESL) is designed and manufactured (618), although this is much simpler to do than designing and manufacturing a special shaped luminance LED die. The wavelength converter designed and manufactured in 618 may be attached to the die on the submount using conventional techniques. In addition to the relative ease of designing and manufacturing a special wavelength converter per the embodiments described herein, the method illustrated in FIG. 6B also only requires one special part to be designed and manufactured, while the method illustrated in FIG. 6A requires design and manufacture of both a special non-uniform die and a special submount.

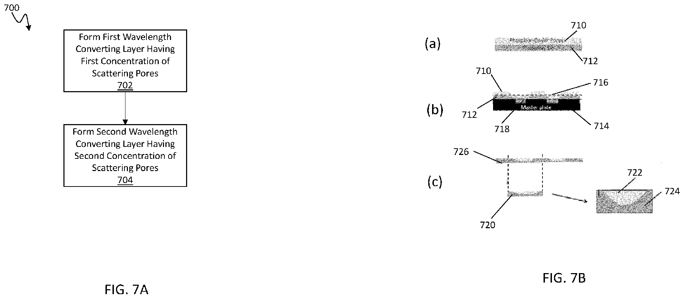

FIG. 7A is a flow diagram 700 of an example method of manufacturing a shaped surface luminance wavelength converter. In the example illustrated in FIG. 7A, a first wavelength converting layer is formed (702). The first wavelength converting layer may have a first concentration of pores. A second wavelength converting layer may be formed (704). The second wavelength converting layer may have a second concentration of pores, which may be larger than the first concentration of pores. The first and second wavelength converting layers may be pressed together.

FIG. 7B includes diagrams of a shaped surface luminance wavelength converter at various steps in a method of manufacture. In (a), the first wavelength converting layer 712 is formed, and the second wavelength converting layer 710 is formed over the first wavelength converting layer 712. The first and second wavelength converting layers may be pressed together to form the wafer structure shown in (a) in FIG. 7B. The structure shown in (a) of FIG. 7B may then be placed on a master plate 718 and punched to form first and second wavelength converting layers having non-uniform thicknesses, as described above. In the example illustrated in (b) in FIG. 7B, the structure has been punched in two locations to create thicker regions of the higher density second layer 716 towards the center of each of a number of wavelength converter platelets in the wafer structure. The wafer structure shown in (b) in FIG. 7B may be removed from the master plate and ground on both the top surface of the second wavelength converting layer to the line 716 shown in (b) and the bottom surface of the first wavelength converting layer to the line 714 shown in (b). A final wafer structure 726 with flat top and bottom surfaces is shown in (c) in FIG. 7B. In (c), the wafer structure 726 may be diced to form individual platelets 720 along the dashed dicing lines shown in (c). An individual platelet is also shown in (c) having the first wavelength converting layer 724 and the second wavelength converting layer 722. In the example illustrated in FIG. 7B, the depths and shapes of the wavelength converting layers within the platelet are different than shown in FIGs. 4A and 4B, which can be done to hone the concentrations and thicknesses of the layers within the platelets to meet different design constraints.

Although features and elements are described above in particular combinations, one of ordinary skill in the art will appreciate that each feature or element can be used alone or in any combination with the other features and elements. In addition, the methods described herein may be implemented in a computer program, software, or firmware incorporated in a computer-readable medium for execution by a computer or processor. Examples of computer-readable media include electronic signals (transmitted over wired or wireless connections) and computer-readable storage media. Examples of computer-readable storage media include, but are not limited to, a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs).

## Claims

1. A shaped surface luminance wavelength converter platelet comprising:
a first wavelength converting layer having a first concentration of scattering pores; and
a second wavelength converting layer over the first wavelength converting layer, the second wavelength converting layer having a second concentration of scattering pores, and the second concentration of scattering pores being larger than the first concentration of scattering pores.

2. The platelet of claim 1, wherein the first wavelength converting layer has a non-uniform width that peaks at a center of the first wavelength converting layer and tapers towards outermost edges of the shaped surface luminance wavelength converter platelet.

3. The platelet of claim 2, wherein a ratio of high density material in a center of the platelet is 50% to 90%, and the ratio of high density material at the outer most edges of the platelet is 0% to 20%.

4. The platelet of claim 1, wherein each of the first wavelength converting layer and the second wavelength converting layer comprises phosphor particles.

5. The platelet of claim 1, wherein the scattering pores are air-filled openings.

6. The platelet of claim 1, wherein the first concentration of scattering pores is in a range between 0.3% and 1.0%.

7. The platelet of claim 5, wherein the second concentration of scattering pores is at least 1.2%.

8. A shaped surface luminance light-emitting diode (LED) die comprising:
a uniform LED die; and
a shaped luminance wavelength converting platelet, over the uniform die, the shaped luminance wavelength converting platelet comprising:
a first wavelength converting layer having a first concentration of scattering pores, and
a second wavelength converting layer over the first wavelength converting layer, the second wavelength converting layer having a second concentration of scattering pores, and the second concentration of scattering pores being larger than the first concentration of scattering pores.

9. The LED die of claim 8, wherein the first wavelength converting layer has a non-uniform width that peaks at a center of the first wavelength converting layer and tapers towards outermost edges of the shaped surface luminance wavelength converter platelet.

10. The LED die of claim 9, wherein a ratio of high density material in a center of the platelet is 70% to 90%, and the ratio of high density material at the outer most edges of the platelet is 0% to 10%.

11. The LED die of claim 8, wherein each of the first wavelength converting layer and the second wavelength converting layer each comprise phosphor particles.

12. The LED die of claim 8, wherein the scattering pores are air-filled openings.

13. The LED die of claim 8, wherein the first concentration of scattering pores is in a range between 0.3% and 1.0%.

14. The LED die of claim 8, wherein the second concentration of scattering pores is at least 1.2%.

15. A method of manufacturing a shape luminance wavelength converting platelet, the method comprising:
forming a first wavelength converting layer having a first concentration of scattering pores; and
forming a second wavelength converting layer over the first wavelength converting layer, the second wavelength converting layer having a second concentration of scattering pores, and the second concentration of scattering pores being larger than the first concentration of scattering pores.

16. The method of claim 15, further comprising pressing the first wavelength converting layer and the second wavelength converting layer together.

17. The method of claim 15, further comprising punching the first and second wavelength converting layers such that the first wavelength converting layer has a non-uniform width that peaks at a center of the first wavelength converting layer and tapers towards outermost edges of the shaped surface luminance wavelength converter platelet.

18. The method of claim 15, further comprising forming the first concentration of scattering pores in the first wavelength converting layer and the second concentration of scattering pores in the second wavelength converting layer by melting poly(Methyl Methacrylate) Microspheres (PMMA) particles in the first and second wavelength converting layers.

19. The method of claim 15, further comprising grinding a top surface of the second wavelength converting layer and a bottom surface of the first wavelength converting layer to form a plate-shaped wafer.

20. The method of claim 19, further comprising dicing the plate-shaped wafer into individual wavelength converting platelets.
